# EUROPÄISCHE PATENTSCHRIFT

(11) **EP 3 747 048 B1**
(45) Veröffentlichungstag und Bekanntmachung des Hinweises auf die Patenterteilung: **09.07.2025**
(21) Anmeldenummer: 19702592.7
(22) Anmeldetag: 30.01.2019
(51) Int. Cl.: H01L 23/538

(54) **ELEKTRONISCHES BAUELEMENT**
ELECTRONIC COMPONENT
COMPOSANT ÉLECTRONIQUE

(30) Priorität: 31.01.2018 DE 102018102144
(43) Veröffentlichungstag der Anmeldung: 09.12.2020
(73) Patentinhaber: TDK Electronics AG, 81671 München (DE)
(72) Erfinder: FEICHTINGER, Thomas, 8010 Graz (AT); PICHLER, Johann, 8614 Breitenau am Hochlantsch (AT); REIMER, Nele, 24937 Flensburg (DE); KOINI, Markus, 8054 Seiersberg (AT); SCHWEINZGER, Manfred, 8541 Schwanberg (AT)
(74) Vertreter: Epping - Hermann - Fischer
(86) Internationale Anmeldenummer: PCT/EP2019/052293
(87) Internationale Veröffentlichungsnummer: WO 2019/149778

(56) Entgegenhaltungen:
- EP-A1- 2 988 328
- DE-A1- 102007 036 045
- DE-B3- 10 336 171
- US-A1- 2003 169 575
- US-A1- 2010 216 280
- US-A1- 2015 257 273
- US-A1- 2015 262 902

## Beschreibung

Es wird ein elektronisches Bauelement angegeben.

Beispielsweise kann das elektronische Bauelement als Leistungsmodul mit integrierten funktionellen Strukturen ausgebildet sein. Ein Leistungsmodul ist beispielsweise aus der DE 10 2007 036045 bekannt.

Es gibt Bestrebungen, elektronische Bauelemente, insbesondere Leistungsmodule, sogenannte "System Power Packages", herzustellen, die bei einer Miniaturisierung eine höhere Leistungsdichte und eine höhere mechanische und insbesondere thermomechanische Belastbarkeit aufweisen. Hierbei geht der Trend beispielsweise bei Applikationen mit Leistungshalbleitern und LEDs (LED: "light-emitting diode", Licht emittierende Diode) zu höheren Betriebstemperaturen, nämlich von etwa 125°C zu 175°C oder mehr.

Eine auf Glas und/oder Epoxidharz basierende Laminattechnologie zur Herstellung sogenannter Power-PCBs (PCB: "printed circuit board", Leiterplatte) erlaubt die Integration von thermisch leitfähigen Strukturen und von passiven und aktiven Komponenten über einen sogenannten "Embedding Process". Eine Limitierung besteht aber beispielsweise in der mangelnden Realisierbarkeit von sehr kleinen thermischen Widerständen.

Auch die LTCC-Technologie (LTCC: "low temperature cofired ceramics", Niedertemperatur-Einbrand-Keramik) auf Basis von Glaskeramiken ist auf Grund der geringen thermischen Leitfähigkeit von Glaskeramiken sehr limitiert in der Realisierung von thermisch leitfähigen Pfaden.

Auf AlN basierende Technologien hingegen, die gute Wärmeleitfähigkeiten aufweisen können, sind derzeit limitiert auf auf Oberflächen montierte Komponenten, beispielsweise drahtgebondete oder mittels SMD-Technologie (SMD: "surfacemount device", oberflächenmontiertes Bauelement) aufgelötete Komponenten.

Die TSV-Technologie (TSV: "through-silicon via", Silizium-Durchkontaktierung) ermöglicht einen sehr hohen Integrationsgrad. Diese Technologie ist aufgrund der reduzierten Festigkeit (weniger als 200 MPa) begrenzt für MEMS-Anwendungen (MEMS: "microelectromechanical system", mikroelektromechanisches System) einsetzbar, jedoch nicht für Leistungsmodule mit hohen thermomechanischen Beanspruchungsprofilen.

Zumindest eine Aufgabe von bestimmten Ausführungsformen ist es, ein elektronisches Bauelement anzugeben.

Diese Aufgabe wird durch einen Gegenstand gemäß dem unabhängigen Patentanspruch gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor. Auch wenn hier im Folgenden einige Ausführungsformen gezeigt und beschrieben werden, so versteht es sich doch, daß die Erfindung nicht durch die Ausführungsformen definiert wird, sondern durch die beigefügten Ansprüche. Dementsprechend sind die Merkmale aus den Ansprüchen nicht als optional anzusehen, selbst wenn sie hier in der Beschreibung in Verbindung mit Wörtern wie "kann" oder "bevorzugt" oder ähnlichen Formulierungen beschrieben sind.

Gemäß zumindest einer Ausführungsform weist ein elektronisches Bauelement zumindest einen Halbleiterchip auf. Der Halbleiterchip kann beispielsweise einen Transistor aufweisen oder ein Transistor sein, beispielsweise ein IGBT ("insulated-gate bipolar transistor", Bipolartransistor mit isolierter Gate-Elektrode) oder ein MOSFET ("metal oxide semiconductor field-effect transistor", Metall-Oxid-Halbleiter-Feldeffekttransistor). Weiterhin kann der Halbleiterchip auch ein anderes Halbleiterbauelement, insbesondere ein Leistungshalbleiterbauelement, und/oder einen optoelektronischen Halbleiterchip wie beispielsweise einen Leuchtdiodenchip aufweisen oder ein solches Bauteil sein. Der Halbleiterchip kann beispielsweise auf SiC, GaAs oder GaN basieren, also ein SiC-, GaAs- oder GaN-Chip sein.

Weiterhin weist das elektronische Bauelement einen ersten Träger auf. Ein Träger kann hier und im Folgenden auch als Substrat, Substratträger oder Strukturkeramik bezeichnet werden. Das elektronische Bauelement kann auch als Systempackage bezeichnet werden.

Der erste Träger weist eine Kavität auf, in der der Halbleiterchip angeordnet ist. Der Halbleiterchip ist teilweise versenkt in der Kavität im ersten Träger angeordnet. Mit anderen Worten weist die Kavität eine Tiefe auf, die geringer als die Dicke des Halbleiterchips ist, so dass der Halbleiterchip teilweise aus der Kavität herausragt. Weiterhin kann der erste Träger eine ebene Oberfläche aufweisen, die die Kavität vollständig umgibt. Weiterhin weist das elektronische Bauelement einen zweiten Träger auf, wobei der zweite Träger auf dem ersten Träger angeordnet ist und den Halbleiterchip in der Kavität überdeckt. Insbesondere kann der Halbleiterchip hierdurch hermetisch in der Kavität eingeschlossen sein. Der zweite Träger weist eine Kavität auf, in der der herausragende Teil des Halbleiterchips angeordnet ist. Besonders bevorzugt können in diesem Fall die Kavität des ersten Trägers und die Kavität des zweiten Trägers bzw. des Kühlelements symmetrisch ausgebildet sein.

Der erste Träger und/oder der zweite Träger können eines oder mehrere der folgenden Merkmale aufweisen:
1. Ein elektrisch leitendes oder elektrisch isolierendes Keramikmaterial, insbesondere ausgewählt aus AlN, BN, Al₂O₃, SiC, SiN, ZnO, BeO.
2. Eine metallische Schicht, besonders bevorzugt aufweisend ein Material ausgewählt aus Cu, Ag, W, Mo, Ti, Au, Ni, Zn sowie Mischungen und Legierungen damit, auf zumindest einer Oberfläche, insbesondere auf zumindest einer dem Halbleiterchip, dem anderen Träger oder einem Kühlelement zugewandten oder abgewandten Oberfläche. Insbesondere kann zumindest einer der Träger ein Keramikmaterial aufweisen, das zwischen zwei metallischen Schichten angeordnet ist.
3. Zumindest ein elektrisches und/oder thermisches Via und/oder zumindest eine Innenelektrode und/oder Leiterbahn, beispielsweise aufweisend ein Material ausgewählt aus Cu, Ag, W, Mo, Ti, Au, Ni, Zn, hierbei bevorzugt Ag und/oder Cu und besonders bevorzugt W, sowie Mischungen und Legierungen mit einem oder mehreren der genannten Materialien. Durch elektrische Vias, Innenelektroden und Leiterbahnen können Verschaltungsstrukturen und Verschaltungsebenen in zumindest einem der Träger ausgebildet sein. Zusammen mit einem geeigneten Keramikmaterial kann zumindest ein Teil eines Trägers hierbei auch eine elektrische Funktionalität aufweisen, beispielsweise in Form eines Varistors, eines PTC-Elements und/oder eines NTC-Elements. Thermische Vias können zur Verbesserung der Wärmeableitung vorhanden sein. Weiterhin kann der erste und/oder zweite Träger in Vielschichttechnologie aufgebaut sein. Insbesondere kann der jeweilige Träger mittels LTCC- oder HTCC-Technologie gefertigt sein.
4. Zumindest eine funktionelle Komponente. Die zumindest eine funktionelle Komponente kann ein passives oder aktives elektronisches oder elektrisches Element aufweisen oder sein. Insbesondere kann die zumindest eine funktionelle Komponente eines oder mehrere der folgenden Elemente aufweisen:
   - ein PTC-Element,
   - ein NTC-Element,
   - einen Varistor,
   - einen Ableiter,
   - ein Vielschichtbauelement,
   - eine Induktivität,
   - eine Kapazität,
   - ein ohmscher Widerstand.

Die zumindest eine funktionelle Komponente kann in Form eines diskreten Bauteils, das in den ersten oder zweiten Träger integriert ist, ausgebildet sein. Alternativ hierzu kann die zumindest eine funktionelle Komponente durch einen Teilbereich des ersten und/oder zweiten Trägers gebildet werden. In diesem Fall kann der erste oder zweite Träger im besagten Teilbereich ein Keramikmaterial und Innenelektrodenschichten aufweisen, die die funktionelle Komponente bilden.

Im Falle eines diskreten Bauteils kann die zumindest eine funktionelle Komponente bevorzugt in einer Kavität im ersten oder zweiten Träger, alleine oder mit zumindest einer oder mehreren weiteren funktionellen Komponenten, angeordnet sein, insbesondere vollständig oder teilweise versenkt. Die Kavität kann an eine Oberseite des Trägers angrenzen oder auch im Inneren des Trägers ausgebildet sein. Insbesondere kann eine Verschaltung der zumindest einen funktionellen Komponente sowie auch des Halbleiterchips mittels Vias, Innenelektroden und Leiterbahnen erfolgen, die im jeweiligen Träger ausgebildet sind. Insbesondere können mehrere gleiche oder verschiedene funktionelle Komponenten in ersten und/oder zweiten Träger integriert sein. Die eine oder die mehreren Komponenten können durch die Anordnung in einer oder mehreren Kavitäten besonders bevorzugt hermetisch verkapselt sein, beispielsweise durch eine Kavität im Inneren eines Trägers oder durch eine Kavität an einer Oberseite eines Trägers, die durch einen anderen Träger, eine metallische Schicht und/oder ein Kühlelement bedeckt und verschlossen ist.

Weiterhin kann auf einer Oberfläche des ersten und/oder zweiten Trägers ein Kühlelement angeordnet sein. Das Kühlelement kann besonders bevorzugt auf einer dem Halbleiterchip abgewandten Oberseite des jeweiligen Trägers angeordnet sein. Weiterhin kann auch auf jedem Träger jeweils ein Kühlelement angeordnet sein, das beispielsweise ein Wärmespreizer, ein Luftkühler und/oder ein Wasserkühler sein kann. Das Kühlelement kann beispielsweise einen Kühlkörper, vorzugsweise mit oder aus Metall, aufweisen, der auf einer Außenseite Kühlrippen, Kühlfinnen oder andere oberflächenvergrößernde Strukturen aufweist.

Weiterhin kann zumindest zwischen dem ersten und zweiten Träger und/oder zumindest zwischen einem Träger und einem Kühlelement eine Verbindungsschicht angeordnet sein. Die Verbindungsschicht kann eines oder mehrere der folgenden Materialien aufweisen:
- Glas;
- Metall, insbesondere eines oder mehrere ausgewählt aus Mikro-Silber (µAg), beispielsweise für eine Sinterschicht, Ag, Au, beispielsweise für eine auf Thermosonic Bonding basierende Verbindungstechnik, AuSn, beispielsweise für eine auf Thermokompressionsbonden basierende Verbindungstechnik, SnAgCu, Cu-Si₃N₄-Cu, beispielsweise für Lötverbindungen;
- Keramik, beispielsweise Si₃N₄ oder, bevorzugt, AlN;
- thermischer Leitkleber, beispielsweise mit Si₃N₄ und/oder AlN gefülltes Epoxidharz.

Weiterhin kann es auch möglich sein, dass der zweite Träger eine Leiterplatte (PCB: "printed circuit board") aufweist oder als Leiterplatte ausgebildet ist.

Das hier beschriebene elektronische Bauelement erlaubt eine Integration von funktionalen aktiven und passiven Strukturen bzw. Komponenten in einem thermischen Substrat bei gleichzeitiger Sicherstellung von thermischer und/oder elektrischer Anbindung der Strukturen oder Komponenten, beispielsweise durch thermisch und/oder elektrisch leitfähige Vias, an/in dem Substrat sowie eine Sicherstellung der Außenkontaktierungungsmöglichkeiten, insbesondere thermisch und/oder elektrisch, des so geschaffenen Gesamtsystems. Weiterhin kann das elektronische Bauelement eine Miniaturisierung bei höherer Leistungsdichte sowie bei höherer mechanischer, insbesondere thermomechanischer, Belastbarkeit sowie einen Betrieb bei Temperaturen von bis zu 175°C und mehr ermöglichen.

Das elektronische Bauelement kann weiterhin eine gute Anpassung der thermomechanischen Dehnungen zwischen den funktionellen Komponenten und der Strukturkeramik und dem Kühlsystem ermöglichen. Weiterhin kann eine vereinfachte Herstellung möglich sein durch die Verwendung möglichst weniger unterschiedlicher Anbindungs- bzw. Fügeverfahren für das Systempackage sowie durch eine weitgehende Verwendung von sogenannten Co-Fireing-Prozessen wie etwa HTCC ("high temperature cofired ceramics", Hochtemperatur-Einbrand-Keramik) oder LTCC ("low temperature cofired ceramics", Niedertemperatur-Einbrand-Keramik) insbesondere für die Herstellung der Träger und deren elektrische und/oder thermische Vias, Leiterbahnen und Innenelektroden im Monolagen- oder Vielschichtaufbau.

Weiterhin kann das elektronische Bauelement die Nutzung der Substratkeramik zur Abbildung passiver Funktionen, beispielsweise insbesondere eine Kondensator- und/oder Ableiterfunktionalität, im Fall eines auf ZnO basierenden Trägers insbesondere auch eine Varistorfunktionalität, ermöglichen durch eine geeignete Ausgestaltung von Innenelektroden und möglicher Hohlraumdesigns in der Auslegung der Substratgeometrie, insbesondere auch der Substratinnengeometrie, und möglicher weiterer passiver Funktionalitäten, insbesondere beispielsweise Funktionalitäten eines Varistors und/oder von PTC- und/oder NTC-Komponenten (PTC: "positive temperature coefficient", Kaltleiter; NTC: "negative temperature coefficient", Heißleiter), durch eine geeignete Wahl der Substratkeramik oder Teilen der Substratkeramik.

Insbesondere kann das hier beschriebene elektronische Bauelement eines oder mehrere der folgenden Merkmale aufweisen:
- Aufbau des ersten Trägers und/oder des zweiten Trägers als thermisches Substrat, insbesondere als Vielschichtsubstrat, mit einer oder mehreren Kavitäten und einer oder mehreren integrierten funktionellen Komponenten.
- Direkte thermische Anbindung der funktionellen Komponenten zum Kühlsystem, insbesondere einem oder mehreren Kühlelementen.
- Hermetische Verkapselung der funktionellen Komponenten.
- Symmetrischer Aufbau zur Kompensation von thermomechanischen Stress, insbesondere durch die Verwendung des ersten Trägers in Kombination mit dem zweiten Träger und/oder durch die Anordnung von zwei Kühlelementen auf verschiedenen Seiten des ersten Trägers oder auf verschiedenen Seiten der Kombination aus beiden Trägern.
- Durch eine symmetrische Anbindung des Halbleiterchips kann die bessere thermische Leitfähigkeit ausgenutzt werden.

Die vorliegend beschriebene Technologie ermöglicht den Aufbau eines elektronischen Bauelements, insbesondere eines kompakten Leistungsmoduls wie etwa eines IGBT-Moduls oder eines Power-MOSFET-Moduls, mit einer oder mehreren der folgenden vorteilhaften Eigenschaften im Vergleich zum Stand der Technik:
- höhere mechanische Robustheit;
- höhere Leistungsdichte;
- geringere thermische Widerstände;
- verbesserte Anpassung der thermischen Dehnungsunterschiede zwischen Komponenten und thermischen Strukturkeramiken;
- bessere Anbindungsmöglichkeit zu Kühlsystemen;
- vereinfachtes Herstellungsverfahren.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
- Figur 1: eine schematische Darstellung eines elektronischen Bauelements gemäß einem Ausführungsbeispiel,
- Figur 2: eine schematische Darstellung eines elektronischen Bauelements gemäß einem weiteren Ausführungsbeispiel und
- Figur 3: eine schematische Darstellung eines elektronischen Bauelements gemäß einem weiteren Ausführungsbeispiel.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

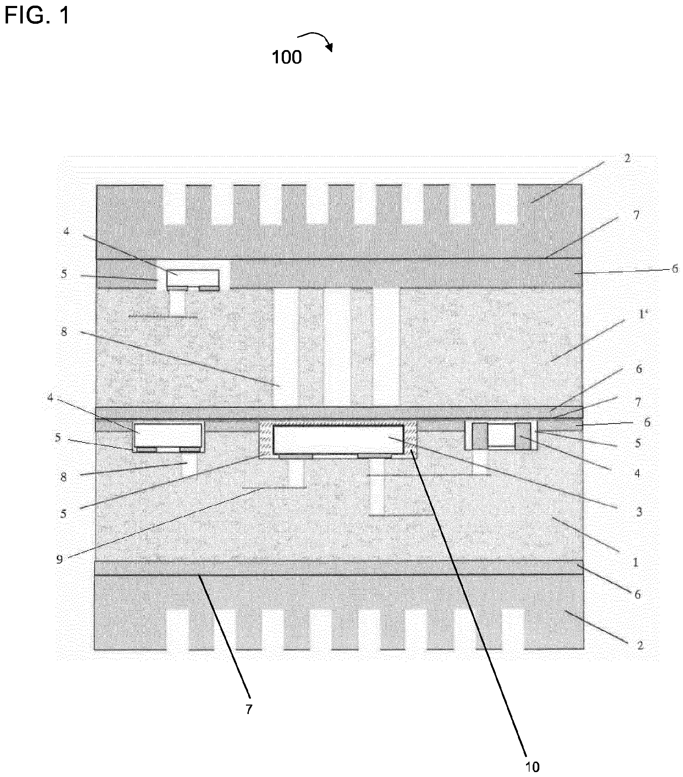

In Figur 1 ist ein Ausführungsbeispiel für ein elektronisches Bauelement 100 gezeigt.

Das elektronische Bauelement 100 weist einen ersten und einen zweiten Träger 1, 1' in Form von thermisch leitfähigen Substraten auf, die jeweils einen Keramikkörper mit einem thermisch leitfähigen Keramikmaterial aufweisen, beispielsweise AlN, insbesondere Vielschicht-AlN, BN, Al₂O₃, SiC, SiN, ZnO und/oder BeO. Auf den Oberseiten der Keramikkörper weisen die Träger 1, 1' metallische Schichten 6 auf, beispielsweise ein Material ausgewählt aus Cu, Ag, W, Mo, Ti, Au, Ni, Zn sowie Mischungen und Legierungen damit. Insbesondere können die Träger 1, 1' wie gezeigt jeweils in Form einer Sandwich-Struktur ausgebildet sein, bei der der Keramikkörper zwischen den metallischen Schichten 6 angeordnet ist.

Die Träger 1, 1' sind insbesondere in Vielschichttechnologie ausgebildet, insbesondere LTCC oder HTCC, und weisen integrierte Innenelektroden und Leiterbahnen 9 sowie elektrische und thermische Vias 8 auf. Die Leiterbahnen und die elektrischen Verbindungsvias bilden Verschaltungsstrukturen und Verschaltungsebenen in den Trägern 1, 1', während die thermischen Vias eine integrierte Anbindung zu einem Kühlsystem bieten. Hierzu sind auf den Außenseiten des Laminats aus erstem und zweitem Träger 1, 1' Kühlelemente 2 aufgebracht, die rein beispielhaft als Luftkühler mit Kühlkörpern mit integrierten Kühlrippen ausgebildet sind. Weiterhin sind auch Wärmespreizer und/oder Wasserkühler möglich. Die thermischen Vias 8 des zweiten Trägers 1' ermöglichen einen effektiven Wärmeabtransport vom im Folgenden beschriebenen Halbleiterchip 3 zum auf dem zweiten Träger 1' angeordneten Kühlelement 2.

Die Träger 1, 1' weisen Kavitäten 5 im Keramikmaterial und/oder in einer metallischen Schicht 6 zur Integration des Halbleiterchips 3 und funktioneller Komponenten 4 auf. Im gezeigten Ausführungsbeispiel weist der erste Träger 1 eine Kavität 5 in einer metallischen Schicht 6 und dem Keramikmaterial auf, in der der Halbleiterchip 3, beispielsweise ein Transistor-Chip, etwa ein IGBT oder ein MOSFET, ein anderes Leistungshalbleiterbauelement oder ein Leuchtdiodenchip versenkt angeordnet und über die vorab beschriebene Verschaltungsstruktur elektrisch und thermisch angeschlossen ist. In weiteren ähnlichen Kavitäten 5 sind aktive oder passive funktionelle Komponenten 4 angeordnet. Die Kavitäten 5 können besonders bevorzugt passgenau im Hinblick auf den Halbleiterchip 3 bzw. die Komponenten 4 ausgebildet sein.

Durch die Anordnung des zweiten Trägers 1' über den Kavitäten 5 des ersten Trägers 1 können die in den Kavitäten angeordneten Elemente hermetisch verkapselt werden. Der zweite Träger 1' weist eine Kavität 5 in einer metallischen Schicht 6 auf, in der ebenfalls eine funktionelle Komponente 4 angeordnet und elektrisch und thermisch angeschlossen ist. Durch die Anordnung eines der Kühlelemente 2 darüber kann auch diese Kavität hermetisch verschlossen werden. Die Kavitäten 5 können, wie im Falle der Kavität 5 für den Halbleiterchip 3 angedeutet, mit einem Verguss 10 in Form eines thermisch leitfähigen Füllmaterials, beispielsweise einem thermisch leitfähigen Kunststoffmaterial, gefüllt sein. Weiterhin kann das Vergussmaterial auch ein feingemahlenes Keramikpulver, beispielsweise AlN, oder ein Matrixmaterial wie etwa Glas oder Kunststoff mit einem eingebetteten Keramikpulver, beispielsweise AlN, aufweisen oder sein. Die funktionellen Komponenten 4 können gleich oder verschieden sein und beispielsweise ausgewählt sein aus PTC-Elementen, NTC-Elementen, Varistoren, Ableiter, Vielschichtbauelementen, Induktivitäten, Kapazitäten, ohmschen Widerständen.

Zwischen den Trägern 1, 1' sowie zwischen jeweils einem der Träger 1, 1' und dem darauf angeordneten Kühlelement 2 sind Verbindungsschichten 7 angeordnet. Die Verbindungsschichten 7 können alle gleich oder verschieden ausgebildet sein und beispielsweise Glas, Metall oder ein Keramikmaterial, etwa Si₃N₄, AlN, Ag, Au, AuSn und/oder SnAgCu, aufweisen. Weiterhin ist auch ein thermischer Leitkleber möglich. Vorteilhafte Verbindungstechnologien können beispielsweise die folgenden sein:
- Keramik-Glas-Keramik;
- Keramik-Metall-Keramik, insbesondere Silbersintern mit µAg, Thermosonic Bonding mit Au, Thermokompressionsbonden mit AuSn, Au, Verlöten mit AuSn, SnAgCu, Cu-Si₃N₄-Cu.

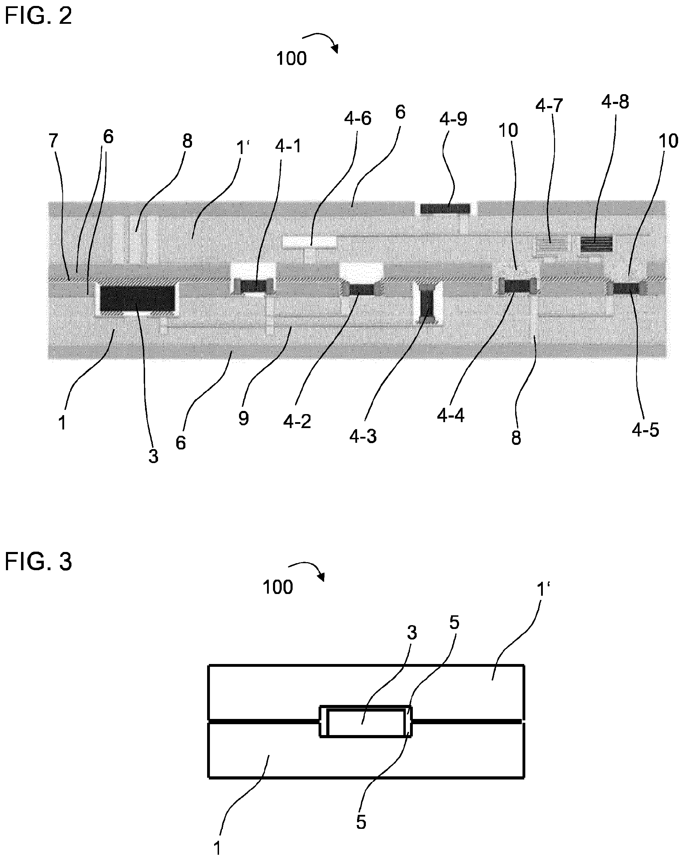

In Figur 2 ist ein weiteres Ausführungsbeispiel für ein elektronisches Bauelement 100 gezeigt, das zusätzlich zum Halbleiterchip 3, der als Leistungshalbleiter und/oder als Flip-Chip ausgebildet sein kann, eine Vielzahl von funktionellen Komponenten 4-1, ..., 4-9 in Kavitäten im ersten und zweiten Träger 1, 1' bzw. durch Teilbereiche des ersten oder zweiten Trägers 1, 1' gebildet aufweist, wobei der Übersichtlichkeit halber die Kavitäten nicht mit Bezugszeichen versehen sind. Die Anzahl, Anbindungsweise und Verschaltung der gezeigten funktionellen Komponenten 4-1, ..., 4-9 sind rein beispielhaft zu verstehen und können von dem in Figur 2 gezeigten Ausführungsbeispiel abweichen.

Das in Figur 2 gezeigte elektronische Bauelement 100 weist im Vergleich zum vorherigen Ausführungsbeispiel keine Kühlelemente auf. Alternativ hierzu können auch Kühlelemente wie in Verbindung mit Figur 1 beschrieben vorhanden sein. Der erste und zweite Träger 1, 1' sind jeweils in Vielschichttechnologie hergestellt und bilden keramische Substrate mit einer Substratkeramik, beispielsweise ein in Verbindung mit dem vorherigen Ausführungsbeispiel genanntes Keramikmaterial.

Die funktionellen Komponenten 4-1, ..., 4-9 können gleich oder verschieden sein und beispielsweise ausgewählt sein aus aktiven oder passiven Komponenten wie PTC-Elementen, NTC-Elementen, Varistoren, Ableitern, Vielschichtbauelementen. Insbesondere handelt es sich im gezeigten Ausführungsbeispiel bei den Komponenten 4-1, ..., 4-5 um passive Komponenten. Die Komponenten 4-1 und 4-4 sind im gezeigten Ausführungsbeispiel beide SMD-montiert (SMD-standard), wobei die Komponente 4-4 in einem elektrisch nicht-leitenden Verguss 10 angeordnet ist. Die Komponenten 4-2 und 4-5 sind beide seitlich SMD-montiert, wobei die Komponente 4-5 ebenfalls in einem elektrisch nicht-leitenden Verguss 10 angeordnet ist. Die Komponente 4-3 ist vertikal SMD-montiert. Die Komponente 4-6 ist als Ableiter ausgebildet. Die Komponente 4-7 ist als ein durch einen Teilbereich des zweiten Trägers 1' gebildetes Vielschichtbauelement mit der Substratkeramik ausgebildet, während die Komponente 4-8 als ein durch einen Teilbereich des zweiten Trägers 1' gebildetes Vielschichtbauelement mit einer in den Träger 1' integrierten Funktionskeramik ausgebildet ist. Die Komponente 4-9 ist ein als Flip-Chip ausgebildetes passives Bauelement.

Zusätzlich zu den gezeigten Komponenten können in den gezeigten Ausführungsbeispielen funktionelle Komponenten wie beispielsweise Widerstände, Induktivitäten und/oder Kapazitäten über Pasten realisiert werden.

Alternativ zu den gezeigten Ausführungsbeispielen kann das in Figur 1 gezeigte obere Kühlelement auch direkt auf dem ersten Träger und damit direkt auf den Kavitäten im ersten Träger angeordnet sein, so dass das elektronische Bauelement dann nur einen Träger aufweist. Weiterhin kann auch die obere Hälfte, also in Figur 1 der zweite Träger und das darauf angeordnete Kühlelement, auch nicht vorhanden sein, so dass das elektronische Bauelement dann den halben Aufbau des in Figur 1 gezeigten Ausführungsbeispiels aufweisen kann. Weiterhin kann der zweite Träger auch als PCB ausgebildet sein.

In den Figuren 1 und 2 sind Ausführungsbeispiele für das elektronische Bauelement gezeigt, bei dem der Halbleiterchip vollständig versenkt in einer Kavität im Träger angeordnet ist. Solche Ausführungsformen sind nicht Teil der beanspruchten Erfindung.

In Figur 3 ist ein weiteres Ausführungsbeispiel für ein elektronisches Bauelement 100 gezeigt, bei dem der Halbleiterchip 3 teilweise versenkt in einer Kavität 5 im ersten Träger 1 angeordnet ist. Hierbei weist die Kavität 5 eine Tiefe auf, die geringer als die Dicke des Halbleiterchips 3 ist, so dass der Halbleiterchip 3 teilweise aus der Kavität 5 herausragt. Darüber ist ein zweiter Träger 1' angeordnet, der eine entsprechende Kavität 5 aufweisen, in der der herausragende Teil des Halbleiterchips 3 angeordnet ist. Besonders bevorzugt können die Kavität 5 des ersten Trägers 1 und die Kavität 5 des zweiten Trägers 1' symmetrisch ausgebildet sein, so dass bildlich gesprochen in jedem der Träger 1, 1' nur der halbe Platz vorgesehen ist. Weiterhin kann es auch möglich sein, dass der erste Träger 1 und der zweite Träger 1' im Hinblick auf ihren gesamten Aufbau symmetrisch sind.

### Bezugszeichenliste

- 1: erster Träger
- 1': zweiter Träger
- 2: Kühlelement
- 3: Halbleiterchip
- 4, 4-1, ..., 4-9: funktionelle Komponente
- 5: Kavität
- 6: metallische Schicht
- 7: Verbindungsschicht
- 8: Via
- 9: Leiterbahn
- 10: Verguss
- 100: elektronisches Bauelement

## Patentansprüche

1. Elektronisches Bauelement, aufweisend zumindest einen ersten Träger, einen zweiten Träger und zumindest einen Halbleiterchip,
wobei der erste Träger eine Kavität aufweist, in der der Halbleiterchip angeordnet ist, und
wobei der erste Träger in Vielschichttechnologie aufweisend einen Keramikkörper aufgebaut ist,
wobei auf dem ersten Träger ein zweiter Träger angeordnet ist, der den Halbleiterchip in der Kavität des ersten Trägers überdeckt und der eine Leiterplatte aufweist und/oder in Vielschichttechnologie aufweisend einen Keramikkörper aufgebaut ist,
wobei der zweite Träger eine Kavität aufweist, dadurch charakterisiert, dass der Halbleiterchip teilweise versenkt in der Kavität im
ersten Träger angeordnet ist und einen aus der Kavität des ersten Trägers herausragenden Teil aufweist, der in der Kavität des zweiten Trägers angeordnet ist.

2. Bauelement nach dem vorherigen Anspruch, wobei Kavität des ersten Trägers und die Kavität des zweiten Trägers symmetrisch ausgebildet sind.

3. Bauelement nach Anspruch 1 oder 2, wobei der erste und zweite Träger symmetrisch sind.

4. Bauelement nach einem der vorherigen Ansprüche, wobei der erste Träger und/oder der zweite Träger eines oder mehrere der folgenden Merkmale aufweist:
- ein elektrisch leitendes oder elektrisch isolierendes Keramikmaterial, insbesondere ausgewählt aus AlN, BN, Al₂O₃, SiC, SiN, ZnO, BeO;
- eine metallische Schicht, besonders bevorzugt aufweisend ein Material ausgewählt aus Cu und/oder, Ag, W, Mo, Ti, Au, Ni, Zn sowie Mischungen und Legierungen damit, auf zumindest einer Oberfläche, insbesondere auf zumindest einer dem anderen Träger zugewandten oder abgewandten Oberfläche;
- zumindest ein elektrisches und/oder thermisches Via und/oder zumindest eine Innenelektrode und/oder Leiterbahn;
- zumindest eine funktionelle Komponente.

5. Bauelement nach einem der vorherigen Ansprüche, wobei der erste und/oder zweite Träger thermische Vias aufweist, die eine integrierte thermische Anbindung zu einem Kühlsystem bieten.

6. Bauelement nach einem der vorherigen Ansprüche, wobei auf einer Oberfläche des ersten und/oder zweiten Trägers ein Kühlelement angeordnet ist.

7. Bauelement nach dem vorherigen Anspruch, wobei das Kühlelement als Luftkühler mit einem Kühlkörper mit integrierten Kühlrippen, als Wärmespreizer und/oder als Wasserkühler ausgebildet ist.

8. Bauelement nach einem der vorherigen Ansprüche, wobei zumindest zwischen dem ersten und zweiten Träger und/oder zumindest zwischen einem der Träger und einem Kühlelement eine Verbindungsschicht angeordnet ist.

9. Bauelement nach dem vorherigen Anspruch, wobei die Verbindungsschicht eines oder mehrere der folgenden Materialien aufweist:
- Glas,
- Metall, insbesondere eines oder mehrere ausgewählt aus Mikro-Silber, Ag, Au, AuSn, SnAgCu, Cu-Si₃N₄-Cu,
- Keramik, beispielsweise Si₃N₄ und/oder AlN
- thermischer Leitkleber, beispielsweise mit Si₃N₄ und/oder AlN gefülltes Epoxidharz.

10. Bauelement nach Anspruch 4 oder einem der Ansprüche 5 bis 9 mit Rückbezug auf Anspruch 4, wobei die zumindest einen funktionelle Komponente eines oder mehrere der folgenden Elemente aufweist:
- ein PTC-Element,
- ein NTC-Element,
- einen Varistor,
- einen Ableiter,
- ein Vielschichtbauelement,
- eine Induktivität,
- eine Kapazität,
- ein ohmscher Widerstand.

11. Bauelement nach Anspruch 4 oder einem der Ansprüche 5 bis 10 mit Rückbezug auf Anspruch 4, wobei die zumindest eine funktionelle Komponente in Form eines diskreten Bauteils in einer Kavität angeordnet ist.

12. Bauelement nach Anspruch 4 oder einem der Ansprüche 5 bis 10 mit Rückbezug auf Anspruch 4, wobei die zumindest eine funktionelle Komponente durch einen Teilbereich des ersten und/oder zweiten Trägers gebildet wird.

## Claims

1. Electronic component, comprising at least a first carrier, a second carrier and at least one semiconductor chip,
wherein the first carrier comprises a cavity in which the semiconductor chip is arranged, and
wherein the first carrier is constructed using multilayer technology comprising a ceramic body,
wherein on the first carrier a second carrier is arranged, which covers the semiconductor chip in the cavity of the first carrier and which comprises a printed circuit board and/or is constructed using multilayer technology comprising a ceramic body,
wherein the second carrier comprises a cavity, **characterized in that**
the semiconductor chip is arranged partially countersunk in the cavity in the first carrier and has a portion which protrudes from the cavity of the first carrier and which is arranged in the cavity of the second carrier.

2. Component according to the preceding claim, wherein the cavity of the first carrier and the cavity of the second carrier are embodied symmetrically.

3. Component according to Claim 1 or 2, wherein the first and second carriers are symmetrical.

4. Component according to any of the preceding claims, wherein the first carrier and/or the second carrier comprise(s) one or more of the following features:
- an electrically conducting or electrically insulating ceramic material, in particular selected from AlN, BN, Al₂O₃, SiC, SiN, ZnO, BeO;
- a metallic layer, particularly preferably comprising a material selected from Cu and/or Ag, W, Mo, Ti, Au, Ni, Zn and mixtures and alloys thereof, on at least one surface, in particular on at least one surface facing towards or away from the other carrier;
- at least one electrical and/or thermal via and/or at least one internal electrode and/or conductor track;
- at least one functional component.

5. Component according to any of the preceding claims, wherein the first and/or second carrier comprise(s) thermal vias which provide an integrated thermal link to a cooling system.

6. Component according to any of the preceding claims, wherein a cooling element is arranged on a surface of the first and/or second carrier.

7. Component according to the preceding claim, wherein the cooling element is embodied as an air cooler with a heat sink with integrated cooling fins, as a heat spreader and/or as a water cooler.

8. Component according to any of the preceding claims, wherein a bonding layer is arranged at least between the first and second carriers and/or at least between one of the carriers and a cooling element.

9. Component according to the preceding claim, wherein the bonding layer comprises one or more of the following materials:
- glass,
- metal, in particular one or more selected from micro-silver, Ag, Au, AuSn, SnAgCu, Cu-Si₃N₄-Cu,
- ceramic, for example Si₃N₄ and/or AlN
- thermal conductive adhesive, for example epoxy resin filled with Si₃N₄ and/or AlN.

10. Component according to Claim 4 or any of Claims 5 to 9 referring back to Claim 4, wherein the at least one functional component comprises one or more of the following elements:
- a PTC element,
- an NTC element,
- a varistor,
- an arrester,
- a multilayer component,
- an inductor,
- a capacitor,
- an ohmic resistor.

11. Component according to Claim 4 or any of Claims 5 to 10 referring back to Claim 4, wherein the at least one functional component in the form of a discrete component part is arranged in a cavity.

12. Component according to Claim 4 or any of Claims 5 to 10 referring back to Claim 4, wherein the at least one functional component is formed by a sub-region of the first and/or second carrier.

## Revendications

1. Composant électronique, comprenant au moins un premier support, un second support et au moins une puce semi-conductrice,
le premier support présentant une cavité dans laquelle est disposée la puce semi-conductrice, et
le premier support étant constitué d'un corps en céramique réalisé en technologie multicouche,
un second support étant disposé sur le premier support qui recouvre la puce semi-conductrice dans la cavité du premier support et qui comprend une carte de circuit imprimé et/ou est constitué d'un corps en céramique réalisé en technologie multicouche,
le second support présentant une cavité,
**caractérisé en ce que**
la puce semi-conductrice est disposée partiellement enfoncée dans la cavité du premier support et présentant une partie saillante hors de la cavité du premier support, laquelle partie est disposée dans la cavité du second support.

2. Composant selon la revendication précédente, dans lequel la cavité du premier support et la cavité du second support sont réalisées symétriquement.

3. Composant selon la revendication 1 ou 2, dans lequel les premier et second supports sont symétriques.

4. Composant selon l'une quelconque des revendications précédentes, dans lequel le premier support et/ou le second support présentent une ou plusieurs des caractéristiques suivantes :
- un matériau céramique électriquement conducteur ou électriquement isolant, choisi en particulier parmi AlN, BN, Al₂O₃, SiC, SiN, ZnO, BeO ;
- une couche métallique, comprenant de manière particulièrement préférée un matériau choisi parmi Cu et/ou Ag, W, Mo, Ti, Au, Ni, Zn ainsi que des mélanges et des alliages de ceux-ci, sur au moins une surface, en particulier sur au moins une surface tournée vers ou à l'opposé de l'autre support ;
- au moins un trou traversant électrique et/ou thermique et/ou au moins une électrode interne et/ou une piste conductrice ;
- au moins un composant fonctionnel.

5. Composant selon l'une quelconque des revendications précédentes, dans lequel le premier et/ou le second support présente des trous traversants thermiques qui offrent une connexion thermique intégrée à un système de refroidissement.

6. Composant selon l'une quelconque des revendications précédentes, dans lequel un élément de refroidissement est disposé sur une surface du premier et/ou du second support.

7. Composant selon la revendication précédente, dans lequel l'élément de refroidissement est réalisé sous forme de refroidisseur à air comportant un dissipateur thermique à ailettes de refroidissement intégrées, sous forme de répartiteur de chaleur et/ou sous forme de refroidisseur à eau.

8. Composant selon l'une quelconque des revendications précédentes, dans lequel une couche de liaison est disposée au moins entre le premier et le second support et/ou au moins entre l'un des supports et un élément de refroidissement.

9. Composant selon la revendication précédente, dans lequel la couche de liaison comprend un ou plusieurs des matériaux suivants :
- du verre,
- un métal, en particulier un ou plusieurs métaux choisis parmi le micro-argent, Ag, Au, AuSn, SnAgCu, Cu-Si₃N₄-Cu,
- une céramique, par exemple Si₃N₄ et/ou AlN,
- un adhésif thermoconducteur, par exemple une résine époxy chargée avec du Si₃N₄ et/ou de l'AlN.

10. Composant selon la revendication 4 ou l'une quelconque des revendications 5 à 9 se référant à la revendication 4, dans lequel l'au moins un composant fonctionnel comprend un ou plusieurs des éléments suivants :
- un élément PTC,
- un élément NTC,
- une varistance,
- un parafoudre,
- un composant multicouche,
- une inductance,
- une capacité,
- une résistance ohmique.

11. Composant selon la revendication 4 ou l'une quelconque des revendications 5 à 10 se référant à la revendication 4, dans lequel l'au moins un composant fonctionnel est disposé sous la forme d'un composant discret dans une cavité.

12. Composant selon la revendication 4 ou l'une quelconque des revendications 5 à 10 se référant à la revendication 4, dans lequel l'au moins un composant fonctionnel est formé par une partie du premier et/ou du second support.
